# EUROPÄISCHE PATENTSCHRIFT

(11) **EP 0 927 457 B1**
(45) Veröffentlichungstag und Bekanntmachung des Hinweises auf die Patenterteilung: **18.07.2001**
(21) Anmeldenummer: 97941845.6
(22) Anmeldetag: 28.08.1997
(51) Int. Cl.: H03H 9/64, H03H 9/145

(54) **OBERFLÄCHENWELLENFILTER**
SURFACE WAVE FILTER
FILTRE A ONDES DE SURFACE

(30) Priorität: 19.09.1996 DE 19638400
(43) Veröffentlichungstag der Anmeldung: 07.07.1999
(73) Patentinhaber: EPCOS AG, 81541 München (DE)
(72) Erfinder: BAIER, Thomas, D-81539 München (DE); OSTNER, Helmut, D-81675 München (DE); SCHROPP, Isidor, D-85119 Ernsgaden (DE)
(74) Vertreter: Epping, Wilhelm, Dipl.-Ing.
(86) Internationale Anmeldenummer: DE9701879
(87) Internationale Veröffentlichungsnummer: WO9812808

(56) Entgegenhaltungen:
- PATENT ABSTRACTS OF JAPAN vol. 018, no. 010 (E-1487), 10.Januar 1994 & JP 05 251987 A (HITACHI LTD;OTHERS: 01), 28.September 1993,
- PATENT ABSTRACTS OF JAPAN vol. 096, no. 009, 30.September 1996 & JP 08 139559 A (KYOCERA CORP), 31.Mai 1996,

## Beschreibung

Die Erfindung betrifft ein Oberflächenwellenfilter nach dem Oberbegriff des Patentanspruches 1.

Aus der JP-A-5-251987 ist ein Oberflächenwellenfilter bekannt, welches aus zwei in Serie geschalteten Einzelfiltern besteht. Zur Impedanzanpassung weist dieses Filter eine variable Anzahl von Anpassungsschaltkreisen auf, die jeweils parallele und serielle Induktivitäten umfassen.

Aus der JP-A-8-139559 ist ein Oberflächenwellenfilter bekannt, welches zwei kaskadierte Einzelfilterstrukturen aufweist. Parallel zu den Ein- und Ausgangswandlern sind zur Impedanzanpassung Induktivitäten geschaltet.

Bei Oberflächenwellenfiltern - im folgenden kurz OFW-Filter genannt - lassen sich große Sperr- bzw. Filterselektionen nur durch Kaskadierung mehrerer OFW-Einzelfilterstrukturen erzielen, die erforderlichenfalls auch in einem gemeinsamen Gehäuse untergebracht sein können. Da die Filterimpedanzen häufig einen kapazitiven Blindanateil besitzen, herrscht jedoch in diesen Fällen bei der Kaskadierung ohne zusätzliche Anpaßelemente zwischen den Einzelfiltern elektrische Fehlanpassung. Die Folgen dieser Fehlanpassung sind höhere Einfügedämpfung, geringere Bandbreite und instabilere Anpaßbarkeit.

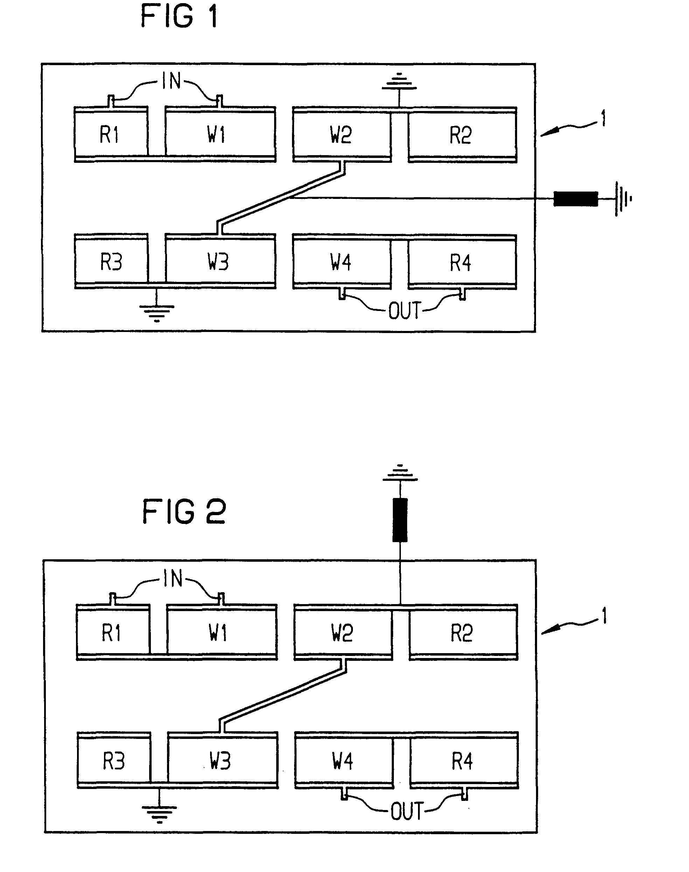

Es ist bereits bekannt, die kapazitiven Blindanteile der Koppelwandler und der Gehäusedurchführung durch eine Parallelinduktivität, nämlich eine zu den Koppelwandlern W2 und W3 parallel geschaltete sogenannte Koppelspule L_{P}, zu kompensieren, wie dies bei dem in Fig. 1 schematisch dargestellten Filter 1 veranschaulicht ist. Dieses Filter besteht dabei aus zwei zu einem Gesamtfilter 1 kaskadierten OFW-Einzelfiltern mit den Wandlern W1, W2 bzw. W3, W4 und Reflektoren R1 bis R4, die teils als Filter 1 bzw. Ausgangswandler W1 bzw. W4 und Koppelwandler W2 bzw. W3 wirken.

Wird dieses bekannte Filter ohne Koppelspule L_{P} betrieben, so liegt der kapazitive Blindanteil der Gehäusedurchführung bzw. die Gehäusedurchführungskapazität parallel zu den Koppelwandlern W2, W3, wodurch die Filtereigenschaften sich im Vergleich zu einem Filter ohne Gehäusedurchführung wesentlich verschlechtern.

Der vorliegenden Erfindung liegt die Aufgabe zugrunde, ein OFW-Filter mit kaskadierten Einzelfilterstrukturen und induktiver Kompensation der kapazitiven Blindanteile seiner Koppelwandler und Gehäusedurchführung zu schaffen, das jedoch im Unterschied zum vorstehend erläuterten bekannten Filter ohne Verschlechterung seiner Filtereigenschaften auch ohne Koppelinduktivität betreibbar ist.

Diese Aufgabe wird bei einem OFW-Filter der eingangs genannten Art erfindungsgemäß dadurch gelöst, daß die kapazitiven Blindanteile durch Serienverschaltung der Koppelwandler mit einer Koppelinduktivität und ohne Parallelinduktivität kompensiert sind.

Die Erfindung wird nachfolgend anhand eines in Figur 2 schematisch dargestellten Ausführungsbeispieles näher erläutert, wobei gemäß Figur 1 gleiche Elemente mit gleichen Bezugszeichen bezeichnet sind.

Man erkennt auch hier die zu einem Gesamtfilter kaskadierten Einzelfilter, wobei jedoch die kapazitiven Blindanteile der Koppelwandler W2, W3 und die Gehäusedurchführungskapazität durch eine Serieninduktivität L_{S} kompensiert sind.

Ersetzt man die Koppelinduktivität L_{S} durch einen Kurzschluß, so erhält man ein kaskadiertes OFW-Filter, bei dem im Gegensatz zum bekannten mit einer Parallelinduktivität ausgestatteten Filter die Gehäusedurchführungskapazität nicht aktiv ist, da sie kurzgeschlossen ist.

Das z.B. in Figur 2 beispielhaft gezeigte OFW-Filter stellt also ein kaskadiertes OFW-Filter dar, das wahlweise mit und ohne Koppelinduktivität betrieben werden kann. Die Filtereigenschaften beim Betrieb ohne Koppelspule verschlechtern sich dabei gegenüber einem für ausschließlichen Betrieb ohne Koppelspule konstruierten Filter nicht, d.h. der Kunde kann ohne Beeinträchtigung der Filtereigenschaften entscheiden, ob er das Filter mit oder ohne Koppelspule betreiben will.

Da im übrigen der Wert der Serieninduktivität im allgemeinen kleiner ist als jener der Parallelinduktivität, kann die Serienspule einfacher im Filtergehäuse oder auf dem Chip bzw. Substrat angeordnet werden als die Parallelspule.

Die Erfindung ist sowohl bei Resonator- als auch Transversalfiltern einsetzbar.

## Patentansprüche

1. Oberflächenwellenfilter mit kaskadierten Einzelfilterstrukturen (R1, W1, W2, R2; R3, W3, W4, R4) und induktiver Kompensation der kapazitiven Blindanteile ihrer Koppelwandler (W2, W3) und Gehäusedurchführung,
dadurch **gekennzeichnet ,**
daß die kapazitiven Blindanteile durch Serienverschaltung der Koppelwandler mit einer Koppelinduktivität (L_{S}) und ohne Parallelinduktivität kompensiert sind.

2. Oberflächenwellenfilter nach Anspruch 1,
dadurch gekennzeichnet, daß die Koppelinduktivität (L_{S}) durch einen Kurzschluß überbrückbar ausgebildet ist.

3. Oberflächenwellenfilter nach Anspruch 1 und 2,
das als Resonatorfilter ausgebildet ist.

4. Oberflächenwellenfilter nach Anspruch 1 und 2,
das als Transversalfilter ausgebildet ist.

## Claims

1. Surface acoustic wave filter having cascaded individual filter structures (R1, W1, W2, R2; R3, W3, W4, R4) and inductive compensation of the capacitive reactive components of their coupling converters (W2, W3) and housing bushing,
characterized
in that the capacitive reactive components are compensated by series connection of the coupling converters with a coupling inductor (L_{S}) and without a parallel inductor.

2. Surface acoustic wave filter according to Claim 1,
characterized in that the coupling inductor (L_{S}) is designed in a manner such that it can be bridged by a short circuit.

3. Surface acoustic wave filter according to Claims 1 and 2,
which is designed as a resonator filter.

4. Surface acoustic wave filter according to Claims 1 and 2,
which is designed as a transversal filter.

## Revendications

1. Filtre à ondes de surface ayant des structures (R1, W1, W2, R2; R3, W3, W4, R4) de filtres individuels en cascade et une compensation inductive des composantes réactives capacitives de leur transformateur (W2, W3) de couplage et de leur traversée de boîtier,
caractérisé en ce que les composantes réactives capacitives sont compensées par montage en série du transformateur de couplage avec une inductance (L_{S}) de couplage et sans inductance parallèle.

2. Filtre à ondes de surface suivant la revendication 1, caractérisé en ce que l'inductance (L_{S}) de couplage est constituée avec possibilité de shuntage par un court-circuit.

3. Filtre à ondes de surface suivant les revendications 1 et 2, caractérisé en ce qu'il est constitué en filtre de résonateur.

4. Filtre à ondes de surface suivant les revendications 1 et 2, caractérisé en ce qu'il est constitué en filtre transversal.
